# EUROPÄISCHE PATENTSCHRIFT

(11) **EP 3 878 248 B1**
(45) Veröffentlichungstag und Bekanntmachung des Hinweises auf die Patenterteilung: **11.02.2026**
(21) Anmeldenummer: 19797262.3
(22) Anmeldetag: 30.10.2019
(51) Int. Cl.: H01M 10/42, H01M 50/516, H01M 50/519, H05K 3/36, H05K 3/40, H05K 3/32

(54) **LEITERPLATTENSYSTEM, ELEKTRISCHER ENERGIESPEICHER UND VERFAHREN ZUM HERSTELLEN EINES LEITERPLATTENSYSTEMS**
PRINTED CIRCUIT BOARD SYSTEM, STORED ELECTRICAL ENERGY SOURCE, AND METHOD FOR PRODUCING A PRINTED CIRCUIT BOARD SYSTEM
SYSTÈME DE CARTE DE CIRCUITS IMPRIMÉS, ACCUMULATEUR D'ÉNERGIE ÉLECTRIQUE ET PROCÉDÉ DE FABRICATION D'UN SYSTÈME DE CARTE DE CIRCUITS IMPRIMÉS

(30) Priorität: 08.11.2018 DE 102018219037
(43) Veröffentlichungstag der Anmeldung: 15.09.2021
(73) Patentinhaber: Robert Bosch GmbH, 70442 Stuttgart (DE)
(72) Erfinder: BORMANN, Axel, 96049 Bamberg (DE); OECHSLE, Matthias, 71254 Ditzingen-Hirschlanden (DE); DITTERT, Thomas, 70199 Stuttgart (DE); PROELL, Johannes, 96052 Bamberg (DE); METZLER, Sebastian, 96135 Stegaurach (DE)
(86) Internationale Anmeldenummer: PCT/EP2019/079652
(87) Internationale Veröffentlichungsnummer: WO 2020/094477

(56) Entgegenhaltungen:
- DE-A1- 102017 204 252
- JP-A- 2013 222 480
- JP-A- H0 738 253
- US-A1- 2017 312 853
- US-A1- 2017 332 492
- GEOFF SHANNON ET AL: "Battery Welding Solutions Using Laser and Resistance Technologies", BATTERY POWER PRODUCTS & TECHNOLOGY, 22 March 2010 (2010-03-22), XP055662608, Retrieved from the Internet <URL:https://dev.amadamiyachi.com/wp-content/uploads/2019/01/Article-Battery-Welding-Solutions-Using-Laser-Resistance-Technologies.pdf> [retrieved on 20200128]

## Beschreibung

### Feld der Erfindung

Die vorliegende Erfindung bezieht sich auf ein Leiterplattensystem, einen elektrischen Energiespeicher und ein Verfahren zum Herstellen eines Leiterplattensystems gemäß dem Oberbegriff der unabhängigen Patentansprüche.

### Stand der Technik

Die DE 10 2015 221 161 A1 zeigt eine Kontaktierungsanordnung, insbesondere für ein Getriebesteuermodul.

Die DE 10 2015 225 369 A1 zeigt eine Kontaktierungseinrichtung, ein Batteriemodul und Verfahren zum Kontaktieren.

Die DE 10 2014 210 576 A1 zeigt eine hermetisch abgedichtete Elektronikeinheit mit flexibler Leiterplatte.

Die DE 10 2010 003 927 A1 zeigt ein Steuermodul für ein Kraftfahrzeuggetriebe.

Die JP2013222480A zeigt eine durch Ultraschallschweißen hergestellte Kontaktierungsanordnung, die insbesondere für einen Schreib-Lese-Kopf einer Festplatte vorgesehen ist.

### Offenbarung der Erfindung

Der Kern der Erfindung bei dem Leiterplattensystem, aufweisend eine Leiterplatte und einen Flachleiter, besteht darin, dass die Leiterplatte eine Kontaktfläche aufweist, wobei der Flachleiter eine Deckfolie, eine Basisfolie und eine zwischengeordnete Leiterfolie aufweist, wobei die Leiterfolie einen Verbindungsbereich aufweist, der in einer Ausnehmung der Deckfolie und der Basisfolie angeordnet ist,
wobei die Kontaktfläche und der Verbindungsbereich stoffschlüssig miteinander verbunden sind,
dadurch gekennzeichnet, dass
die Kontaktfläche (3) und der Verbindungsbereich (7) einen einstückigen Verbindungsabschnitt (30) bilden, der in der Ausnehmung (6) angeordnet ist,
   und
das Leiterplattensystem (1) mehrere Verbindungsabschnitte (30) aufweist.

Hintergrund der Erfindung ist, dass die Kontaktfläche und die Leiterfolie unmittelbar miteinander verbunden sind. Somit ist eine sichere Verbindung herstellbar. Die elektrische Verbindung zwischen der Kontaktfläche und der Leiterfolie ist niederohmig ausführbar.

Weitere vorteilhafte Ausführungsformen der vorliegenden Erfindung sind Gegenstand der Unteransprüche.

Gemäß einer vorteilhaften Ausgestaltung weist die Leiterplatte eine Isolierlage auf, wobei die Kontaktfläche auf der Isolierlage angeordnet ist, insbesondere wobei zwischen der Isolierlage und der Deckfolie ein Verbindungsmittel, insbesondere ein Klebemittel, angeordnet ist. Vorteilhafterweise weisen die Leiterplatte und der Flachleiter eine zusätzliche Verbindung mittels des Klebemittels auf. Dadurch ist die Verbindung zwischen der Kontaktfläche und der Leiterfolie mechanisch entlastbar. Von Vorteil ist es dabei, wenn die Kontaktfläche und der Verbindungsbereich einen einstückigen Verbindungsabschnitt bilden, der in der Ausnehmung angeordnet ist, wobei neben dem Verbindungsabschnitt eine Pore angeordnet ist.

Vorteilhafterweise weist das Leiterplattensystem mehrere Verbindungsabschnitte auf, wobei die Verbindungsabschnitte kreisförmig oder linear angeordnet sind. Dadurch ist die Belastbarkeit der Verbindung verbessert.

Weiterhin ist es von Vorteil, wenn der Verbindungsabschnitt kreisförmig ausgeführt ist, insbesondere wobei der Verbindungsabschnitt einen Durchmesser aufweist, der kleiner als 200 µm ist, insbesondere zwischen 100 und 200 µm groß ist. Somit sind Flachleiter mit dünneren und/oder schmaleren Leiterfolien als im Stand der Technik verwendbar.

Von Vorteil ist es zudem, wenn das Leiterplattensystem ein elektrisches Bauelement aufweist, insbesondere wobei das elektrische Bauelement auf der Leiterplatte oder dem Flachleiter angeordnet ist. Dadurch ist das Leiterplattensystem sowohl als Leiter als auch als elektrisches Bauteil verwendbar.

Der Kern der Erfindung bei dem elektrischen Energiespeicher besteht darin, dass der elektrische Energiespeicher ein Leiterplattensystem wie zuvor beschrieben beziehungsweise nach einem der auf das Leiterplattensystem bezogenen Ansprüche aufweist.

Hintergrund der Erfindung ist, dass der elektrische Energiespeicher kompakt ausführbar ist.

Vorteilhafterweise weist der elektrische Energiespeicher zumindest zwei elektrische Energiespeicherzellen auf, die mittels des Leiterplattensystems verbunden sind. Von Vorteil ist dabei, dass das Leiterplattensystem sowohl als Zellverbinder als auch als Steuerung für die elektrischen Energiespeicherzellen verwendbar ist.

Der Kern der Erfindung bei dem Verfahren zum Herstellen eines Leiterplattensystems, insbesondere wie zuvor beschrieben beziehungsweise nach einem der auf das Leiterplattensystem bezogenen Ansprüche, aufweisend eine Leiterplatte mit einer Kontaktfläche und einen Flachleiter mit einer Leiterfolie ist, dass die Kontaktfläche und die Leiterfolie mittels eines gepulsten Laserstrahls verbunden werden.

Hintergrund der Erfindung ist, dass mittels des gepulsten Laserstrahls weniger Wärmeenergie in das Leiterplattensystem eingebracht wird. Dadurch kann im Fokus des Lasers geschweißt werden, wodurch kleinere Schweißpunkte ermöglicht werden. Somit sind Flachleiter mit dünneren und/oder schmaleren Leiterfolien als im Stand der Technik verwendbar.

Gemäß einer vorteilhaften Ausgestaltung wird ein Laserstrahl mit Frequenzverdopplung verwendet, insbesondere wobei der Laserstrahl eine Wellenlänge von weniger als 600 nm, insbesondere von 532 nm oder 515 nm, aufweist. Dadurch wird die Absorption der Laserstrahlung durch die Leiterfolie, die beispielsweise Kupfer oder Aluminium aufweist, verbessert.

Vorteilhafterweise wird das Leiterplattensystem unter Schutzgasatmosphäre, insbesondere unter Argon, oder an Luft verschweißt.

Von Vorteil ist es dabei, wenn die Leiterfolie bei dem Verbinden mittels eines Haltemittels zu der Kontaktfläche gedrückt wird. Dadurch wird der Abstand zwischen der Leiterfolie und der Kontaktfläche reduziert, insbesondere so dass sich die Leiterfolie und die Kontaktfläche berühren.

Weiterhin ist es von Vorteil, wenn die Leiterfolie in einem Verbindungsbereich schmilzt und eine stoffschlüssige Verbindung mit der Kontaktfläche hergestellt wird. Dabei kann sich neben einem aus dem Verbindungsbereich und der Kontaktfläche gebildeten Verbindungsabschnitt eine Pore bilden, die vollständig von der Kontaktfläche und/oder der Leiterfolie und/oder dem Verbindungsabschnitt und/oder der Isolierlage umgeben ist.

### Kurze Beschreibung der Zeichnungen

Die Ausführungsbeispiele sind in den Zeichnungen dargestellt.

Es zeigen:
- Fig. 1: eine Draufsicht auf ein erfindungsgemäßes Leiterplattensystem 1;
- Fig. 2: eine Schnittdarstellung einer Leiterplatte 8 und eines Flachleiters 9, die mittels eines Laserstrahls 21 und eines Haltemittels 20 zu einem erfindungsgemäßen Leiterplattensystem 1 verbunden werden;
- Fig. 3: eine Detailansicht einer ersten Variante einer Verbindung der Leiterplatte 8 mit dem Flachleiter 9;
- Fig. 4: eine Detailansicht einer zweiten Variante einer Verbindung der Leiterplatte 8 mit dem Flachleiter 9 und
- Fig. 5: eine Schnittdarstellung des Leiterplattensystems 1 nachdem die Leiterplatte 8 und der Flachleiter 9 verbunden wurden.

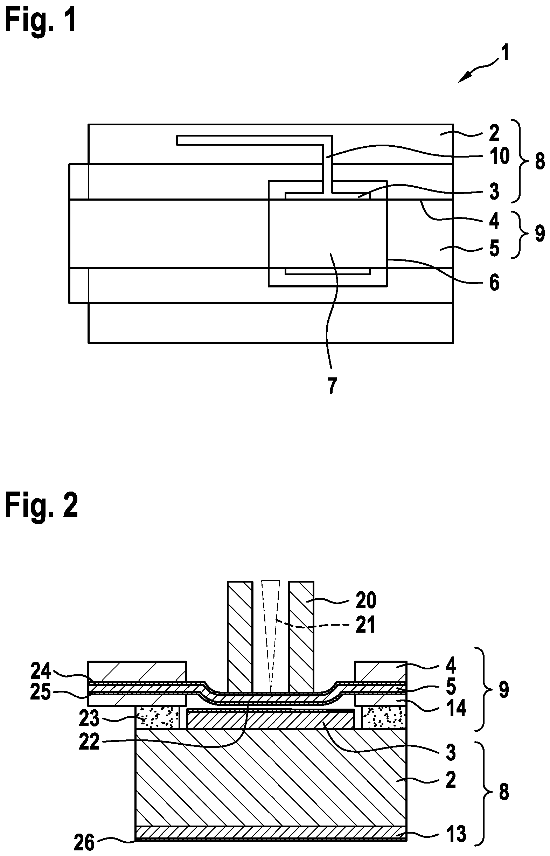

Das in Fig. 1 dargestellte Leiterplattensystem 1 weist eine Leiterplatte 8 und einen Flachleiter 9 auf. Der Flachleiter 9 ist auf der Leiterplatte 8 angeordnet.

Der Flachleiter 9 weist eine Basisfolie 4, eine Leiterfolie 5 und eine Deckfolie 14 auf.

Die Leiterfolie 5 ist zwischen der Basisfolie 4 und der Deckfolie 14 angeordnet. Die Deckfolie 14 ist zumindest teilweise zwischen der Leiterfolie 5 und der Leiterplatte 8 angeordnet.

Die Leiterfolie 5 ist zumindest teilweise eingehüllt mittels der Deckfolie 14 und der Basisfolie 4. Die Deckfolie 14 und die Basisfolie 4 sind elektrisch isolierend ausgeführt. Dabei weist die Basisfolie 4 eine größere Dicke auf als die Deckfolie 14.

Die Leiterfolie 5 ist elektrisch leitfähig ausgeführt, insbesondere aus Kupfer oder Aluminium. Die Leiterfolie 5 ist maximal 100 µm dick, insbesondere zwischen 20 µm und 80 µm dick, vorzugsweise 35 µm oder 70 µm dick.

Die Deckfolie 14 und die Basisfolie 4 des Flachleiters 9 weisen eine Ausnehmung 6 auf. Die Ausnehmung 6 legt die Leiterfolie 5 abschnittweise frei. Die freigelegte Leiterfolie 5 fungiert als Verbindungsbereich 7 für den Flachleiter 9 und die Leiterplatte 8.

Der Flachleiter 9 ist als flexible Leiterplatte ausführbar. Die flexible Leiterplatte ist mehrlagig ausführbar.

Die Leiterplatte 8 weist eine Isolatorlage 2, eine Leiterbahn 10, eine Kontaktfläche 3 und eine Leiterlage 13 auf.

Die Kontaktfläche 3, die Leiterbahn 10 und die Leiterlage 13 sind elektrisch leitfähig ausgeführt, insbesondere aus Kupfer oder Aluminium.

Die Kontaktfläche 3 ist maximal 150 µm dick, insbesondere zwischen 50 µm und 130 µm dick, vorzugsweise 55µm oder 90 µm oder 125 µm dick. Dabei weist die Kontaktfläche 3 eine gleiche oder größere Dicke auf als die Leiterfolie 5 Die Kontaktfläche 3 weist eine Kantenlänge von maximal 5 mm auf, vorzugsweise eine Kantenlänge von 3 mm.

Die Isolatorlage 2 ist elektrisch isolierend ausgeführt.

Die Isolatorlage 2 ist zwischen der Leiterlage 13 und der Leiterbahn 10 angeordnet.

Die Isolatorlage 2 ist zwischen der Leiterlage 13 und der Kontaktfläche 3 angeordnet.

Die Leiterbahn 10 ist elektrisch leitend mit der Kontaktfläche 3 verbunden. Die Kontaktfläche 3 ist auf der Isolatorlage 2 angeordnet, wobei die Kontaktfläche 3 die Isolatorlage 2 teilweise bedeckt.

Der Flachleiter 9 und die Leiterplatte 8 sind mittels der Leiterfolie 5 und der Kontaktfläche 3 miteinander verbunden. Dazu überlappen die Kontaktfläche 3 und der Verbindungsbereich 7 zumindest teilweise. Die Leiterfolie 5 und die Kontaktfläche 3 sind elektrisch leitend miteinander verbunden.

Auf der Oberfläche der Leiterfolie 5 und/oder der Kontaktfläche 3 und/oder der Leiterbahn 10 und/oder der Leiterlage 13 ist eine Zinnschicht (24, 25, 26) angeordnet. Die Zinnschicht (24, 25, 26) ist maximal 10 µm dick, vorzugsweise ist die Zinnschicht 5 µm dick.

Fig. 2 zeigt das Leiterplattensystem 1 kurz vor dem Verbinden der Leiterplatte 8 mit dem Flachleiter 9.

Zwischen der Leiterplatte 8 und dem Flachleiter 9 ist ein Verbindungsmittel 23, insbesondere ein Klebemittel, angeordnet. Das Verbindungsmittel 23 verbindet die Deckfolie 14 und die Isolatorlage 2, es ist beabstandet von der Kontaktfläche 3 angeordnet.

Mittels des Verbindungsmittels 23 sind der Verbindungsbereich 7 und die Kontaktfläche 3 vor dem Verbinden des Leiterplattensystems 1 voneinander beabstandet, so dass zwischen dem Verbindungsbereich 7 und der Kontaktfläche 3 ein Spalt 22 entsteht.

Zum Verbinden des Leiterplattensystems 1 wird ein Haltemittel 20 auf den Verbindungsbereich 7 gedrückt und gehalten, so dass der Abstand zwischen dem Verbindungsbereich 7 und der Kontaktfläche 3 verringert wird, insbesondere soweit dass der Verbindungsbereich 7 und die Kontaktfläche 3 einander berühren. Danach wird der Verbindungsbereich 7 mit der Kontaktfläche 3 mittels eines Laserstrahls 21 verbunden, insbesondere verschweißt. Dadurch werden der Verbindungsbereich 7 und die Kontaktfläche 3 stoffschlüssig miteinander verbunden.

Zur Verbindung des Verbindungsbereichs 7 mit der Kontaktfläche 3 wird ein gepulster Laserstrahl 21 verwendet. Der Laserstrahl 21 weist eine Wellenlänge zwischen 500 nm und 600 nm auf, insbesondere 532 nm oder 515 nm.

Alternativ sind die Kontaktfläche 3 und der Verbindungsbereich 7 mittels Widerstandsschweißens, insbesondere Spaltschweißen oder Stufenschweißen, verbindbar.

Die Kontaktfläche 3 und der Verbindungsbereich 7 sind mittels eines einzigen Verbindungsabschnitts 30, insbesondere mittels eines Schweißpunktes, oder mit mehreren Verbindungsabschnitten 30 miteinander verbunden. Ein Verbindungsabschnitt 30 ist punktförmig ausgeführt und weist einen Durchmesser von maximal 200 µm auf, insbesondere 100 µm bis 200 µm, insbesondere 120 µm bis 170 µm, vorzugsweise 150 µm.

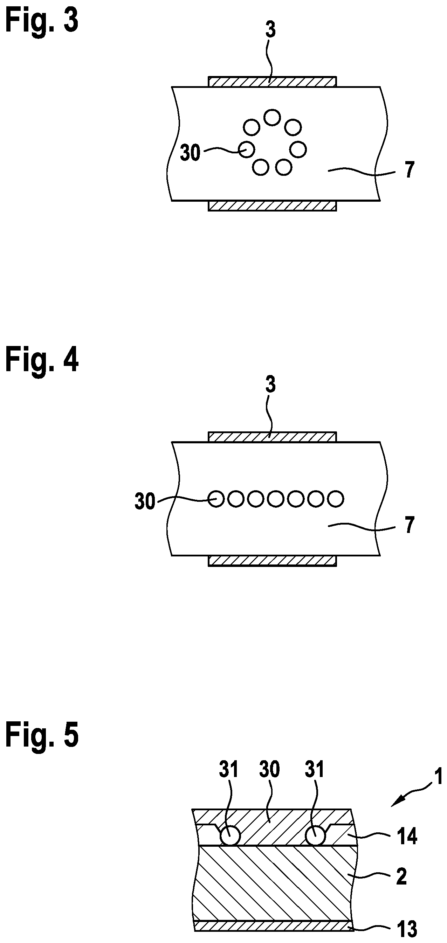

Fig. 3 zeigt eine erste Variante der Verbindung. Dabei sind die Verbindungspunkte 30 kreisförmig angeordnet.

Fig. 4 zeigt eine zweite Variante der Verbindung. Dabei sind die Verbindungspunkte 30 linear angeordnet.

Gemäß einer weiteren Ausführungsform, die in den Figuren nicht dargestellt ist, ist auf der Kontaktfläche 3 eine zusätzliche Verbindungsschicht angeordnet. Die Verbindungsschicht ist beispielsweise aus CuSn6 ausgeführt.

Fig. 5 zeigt das Leiterplattensystem 1 nachdem der Verbindungsbereich 7 und die Kontaktfläche 3 verbunden wurden. Der Verbindungsbereich 7 und die Kontaktfläche 3 sind stoffschlüssig miteinander verbunden und zu einem Verbindungsabschnitt 30 verschmolzen. Der Verbindungsabschnitt 30 erstreckt sich durch die Ausnehmung 6 in der Deckfolie 14 von einer Oberfläche des Leiterplattensystems 1 zu der Isolierlage 2. Zwischen der Deckfolie 14 und dem Verbindungsabschnitt 30 ist zumindest eine Pore 31 angeordnet.

Unter einem elektrischen Energiespeicher wird hierbei ein wiederaufladbarer Energiespeicher verstanden, insbesondere aufweisend eine elektrochemische Energiespeicherzelle und/oder ein Energiespeichermodul aufweisend zumindest eine elektrochemische Energiespeicherzelle und/oder ein Energiespeicherpack aufweisend zumindest ein Energiespeichermodul. Die Energiespeicherzelle ist als lithiumbasierte Batteriezelle, insbesondere Lithium-Ionen-Batteriezelle, ausführbar. Alternativ ist die Energiespeicherzelle als Lithium-Polymer-Batteriezelle oder Nickel-Metallhydrid-Batteriezelle oder Blei-Säure-Batteriezelle oder Lithium-Luft-Batteriezelle oder Lithium-Schwefel-Batteriezelle ausgeführt.

## Patentansprüche

1. Leiterplattensystem (1) aufweisend eine Leiterplatte (8) und einen Flachleiter (9), die Leiterplatte (8) eine Kontaktfläche (3) aufweist,
wobei der Flachleiter (9) eine Deckfolie (14), eine Basisfolie (4) und eine zwischengeordnete Leiterfolie (5) aufweist,
wobei die Leiterfolie (5) einen Verbindungsbereich (7) aufweist, der in einer Ausnehmung (6) der Deckfolie (14) und der Basisfolie (4) angeordnet ist,
wobei die Kontaktfläche (3) und der Verbindungsbereich (7) stoffschlüssig miteinander verbunden sind,
**dadurch gekennzeichnet, dass**
die Kontaktfläche (3) und der Verbindungsbereich (7) einen einstückigen Verbindungsabschnitt (30) bilden, der in der Ausnehmung (6) angeordnet ist, und
das Leiterplattensystem (1) mehrere Verbindungsabschnitte (30) aufweist.

2. Leiterplattensystem (1) nach Anspruch 1,
**dadurch gekennzeichnet, dass**
die Leiterplatte (8) eine Isolierlage (2) aufweist, wobei die Kontaktfläche (3) auf der Isolierlage (2) angeordnet ist,
insbesondere wobei zwischen der Isolierlage (2) und der Deckfolie (14) ein Verbindungsmittel (23), insbesondere ein Klebemittel, angeordnet ist.

3. Leiterplattensystem (1) nach einem der vorhergehenden Ansprüche,
**dadurch gekennzeichnet, dass**
neben dem Verbindungsabschnitt (30) eine Pore (31) angeordnet ist.

4. Leiterplattensystem (1) nach einem der vorhergehenden Ansprüche,
**dadurch gekennzeichnet, dass**
die Verbindungsabschnitte (30) kreisförmig oder linear angeordnet sind.

5. Leiterplattensystem (1) nach Anspruch 3 oder 4,
**dadurch gekennzeichnet, dass**
der Verbindungsabschnitt (30) kreisförmig ausgeführt ist,
insbesondere wobei der Verbindungsabschnitt (30) einen Durchmesser aufweist, der kleiner als 200 µm ist, insbesondere zwischen 100 und 200 µm groß ist.

6. Leiterplattensystem (1) nach einem der vorhergehenden Ansprüche,
**dadurch gekennzeichnet, dass**
das Leiterplattensystem (1) ein elektrisches Bauelement aufweist, insbesondere wobei das elektrische Bauelement auf der Leiterplatte (8) oder dem Flachleiter (9) angeordnet ist.

7. Elektrischer Energiespeicher,
**dadurch gekennzeichnet, dass**
der elektrische Energiespeicher zumindest ein Leiterplattensystem (1) nach einem der Ansprüche 1 bis 6 aufweist.

8. Elektrischer Energiespeicher nach Anspruch 7,
**dadurch gekennzeichnet, dass**
der elektrische Energiespeicher zumindest zwei elektrische Energiespeicherzellen aufweist, die mittels des Leiterplattensystems (1) verbunden sind.

9. Verfahren zum Herstellen eines Leiterplattensystems (1) nach einem der Ansprüche 1 bis 6,
**dadurch gekennzeichnet, dass**
die Kontaktfläche (3) und die Leiterfolie (5) mittels eines gepulsten Laserstrahls (21) verbunden werden.

10. Verfahren nach Anspruch 9,
**dadurch gekennzeichnet, dass**
ein Laserstrahl (21) mit Frequenzverdopplung verwendet wird, insbesondere wobei der Laserstrahl (21) eine Wellenlänge von weniger als 600 nm aufweist,
insbesondere von 532 nm oder 515 nm aufweist.

11. Verfahren nach Anspruch 9 oder 10,
**dadurch gekennzeichnet, dass**
die Leiterfolie (5) bei dem Verbinden mittels eines Haltemittels (20) zu der Kontaktfläche (3) gedrückt wird.

12. Verfahren nach einem der Ansprüche 9 bis 11,
**dadurch gekennzeichnet, dass**
die Leiterfolie (5) in einem Verbindungsbereich (7) schmilzt und eine stoffschlüssige Verbindung mit der Kontaktfläche (3) hergestellt wird.

## Claims

1. Printed circuit board system (1) having a printed circuit board (8) and a flat conductor (9), the printed circuit board (8) having a contact surface (3),
wherein the flat conductor (9) has a cover film (14), a base film (4) and an intermediate conductor film (5),
wherein the conductor film (5) has a connecting region (7) which is arranged in a recess (6) of the cover film (14) and the base film (4),
wherein the contact surface (3) and the connecting region (7) are connected to one another in a materially bonded manner,
**characterized in that**
the contact surface (3) and the connecting region (7) form a one-piece connecting portion (30) which is arranged in the recess (6), and
the printed circuit board system (1) comprises multiple connecting portions (30).

2. Printed circuit board system (1) according to Claim 1,
**characterized in that**
the printed circuit board (8) has an insulating layer (2), wherein the contact surface (3) is arranged on the insulating layer (2),
in particular wherein a connecting means (23), in particular an adhesive, is arranged between the insulating layer (2) and the cover film (14).

3. Printed circuit board system (1) according to one of the preceding claims,
**characterized in that**
a pore (31) is arranged next to the connecting portion (30).

4. Printed circuit board system (1) according to one of the preceding claims,
**characterized in that**
the connecting portions (30) are arranged in a circular or linear manner.

5. Printed circuit board system (1) according to Claim 3 or 4,
**characterized in that**
the connecting portion (30) is circular,
in particular wherein the connecting portion (30) has a diameter smaller than 200 µm, in particular between 100 and 200 µm.

6. Printed circuit board system (1) according to one of the preceding claims,
**characterized in that**
the printed circuit board system (1) has an electrical component, in particular wherein the electrical component is arranged on the printed circuit board (8) or the flat conductor (9).

7. Electrical energy storage device,
**characterized in that**
the electrical energy storage device has at least one printed circuit board system (1) according to one of Claims 1 to 6.

8. Electrical energy storage device according to Claim 7,
**characterized in that**
the electrical energy storage device has at least two electrical energy storage cells which are connected by means of the printed circuit board system (1).

9. Method for producing a printed circuit board system (1) according to one of Claims 1 to 6,
**characterized in that**
the contact surface (3) and the conductor film (5) are connected by means of a pulsed laser beam (21).

10. Method according to Claim 9,
**characterized in that**
a laser beam (21) with frequency doubling is used, in particular wherein the laser beam (21) has a wavelength of less than 600 nm, in particular of 532 nm or 515 nm.

11. Method according to Claim 9 or 10,
**characterized in that**
the conductor film (5) is pressed to the contact surface (3) by means of a holding means (20) during the connection.

12. Method according to one of Claims 9 to 11,
**characterized in that**
the conductor film (5) melts in a connecting region (7) and a materially bonded connection with the contact surface (3) is established.

## Revendications

1. Système de carte de circuits imprimés (1) comportant une carte de circuits imprimés (8) et un conducteur plat (9), la carte de circuits imprimés (8) comportant une surface de contact (3),
le conducteur plat (9) comportant une feuille de recouvrement (14), une feuille de base (4) et une feuille conductrice (5) intercalée,
la feuille conductrice (5) comportant une zone de liaison (7), qui est disposée dans un évidement (6) de la feuille de recouvrement (14) et de la feuille de base (4),
la surface de contact (3) et la zone de liaison (7) étant reliées l'une à l'autre par complémentarité de matières,
**caractérisé en ce que**
la surface de contact (3) et la zone de liaison (7) forment une partie de liaison d'un seul tenant (30) qui est disposée dans l'évidement (6), et
le système de carte de circuits imprimés (1) comporte une pluralité de parties de liaison (30).

2. Système de carte de circuits imprimés (1) selon la revendication 1,
**caractérisé en ce que**
la carte de circuits imprimés (8) comporte une couche isolante (2), la surface de contact (3) étant disposée sur la couche isolante (2),
un moyen de liaison (23), en particulier un adhésif, étant en particulier disposé entre la couche isolante (2) et la feuille de recouvrement (14).

3. Système de carte de circuits imprimés (1) selon l'une des revendications précédentes,
**caractérisé en ce que**
un pore (31) est disposé à côté de la partie de liaison (30).

4. Système de carte de circuits imprimés (1) selon l'une des revendications précédentes,
**caractérisé en ce que**
les parties de liaison (30) sont disposées de manière circulaire ou linéaire.

5. Système de carte de circuits imprimés (1) selon la revendication 3 ou 4,
**caractérisé en ce que**
la partie de liaison (30) est de conception circulaire,
la partie de liaison (30) présentant en particulier un diamètre inférieur à 200 µm, en particulier compris entre 100 et 200 µm.

6. Système de carte de circuits imprimés (1) selon l'une des revendications précédentes,
**caractérisé en ce que**
le système de carte de circuits imprimés (1) comporte un composant électrique, le composant électrique étant en particulier disposé sur la carte de circuits imprimés (8) ou sur le conducteur plat (9).

7. Accumulateur d'énergie électrique,
**caractérisé en ce que**
l'accumulateur d'énergie électrique comporte au moins un système de carte de circuits imprimés (1) selon l'une des revendications 1 à 6.

8. Accumulateur d'énergie électrique selon la revendication 7,
**caractérisé en ce que**
l'accumulateur d'énergie électrique comporte au moins deux cellules d'accumulation d'énergie électrique qui sont reliées par l'intermédiaire du système de carte de circuits imprimés (1).

9. Procédé de fabrication d'un système de carte de circuits imprimés (1) selon l'une des revendications 1 à 6,
**caractérisé en ce que**
la surface de contact (3) et la feuille conductrice (5) sont reliées par un faisceau laser pulsé (21).

10. Procédé selon la revendication 9,
**caractérisé en ce que**
un faisceau laser (21) à doublement de fréquence est utilisé, le faisceau laser (21) présentant en particulier une longueur d'onde inférieure à 600 nm, en particulier de 532 nm ou de 515 nm.

11. Procédé selon la revendication 9 ou 10,
**caractérisé en ce que**
lors de la liaison, la feuille conductrice (5) est pressée contre la surface de contact (3) au moyen d'un moyen de maintien (20).

12. Procédé selon l'une des revendications 9 à 11,
**caractérisé en ce que**
la feuille conductrice (5) fond dans une zone de liaison (7) et **en ce qu'**une liaison par complémentarité de matières avec la surface de contact (3) est réalisée.
